# EUROPÄISCHE PATENTSCHRIFT

(11) **EP 0 653 779 B1**
(45) Veröffentlichungstag und Bekanntmachung des Hinweises auf die Patenterteilung: **29.07.1998**
(21) Anmeldenummer: 94117314.8
(22) Anmeldetag: 03.11.1994
(51) Int. Cl.: H01L 21/00

(54) **Anordnung zur thermischen Behandlung von Halbleitersubstraten**
Thermal treatment device for semiconductor substrates
Dispositif pour traitement thermique de substrats semi-conducteurs

(30) Priorität: 11.11.1993 DE 4338506
(43) Veröffentlichungstag der Anmeldung: 17.05.1995
(73) Patentinhaber: DAIMLER-BENZ AKTIENGESELLSCHAFT, 70546 Stuttgart (DE)
(72) Erfinder: Kibbel, Horst, D-89155 Erbach (DE)
(74) Vertreter: Fröhling, Werner Otto, Dr.

(56) Entgegenhaltungen:
- EP-A- 0 399 616
- EP-A- 0 447 155
- EP-A- 0 451 740
- WO-A-90/12295

## Beschreibung

Die Erfindung betrifft eine Anordnung zur thermischen Behandlung von Halbleitersubstraten.

Zur thermischen Substratbehandlung wird eine ebene Halbleiterscheibe in eine Aufnahme einer Heizvorrichtung eingesetzt, die in geringem Abstand von der Substratebene und parallel zu dieser einen Heizer aufweist. Dieser besteht im Regelfall aus einem elektrisch leitenden Widerstandsmaterial und ist durch eine Strukturierung in der Fläche in einzelne Leiterzüge unterteilt z.B. in Streifen-oder Mäanderform, die durch Durchbrüche im Heizerkörper voneinander getrennt sind.

Der der Substratebene abgewandte rückwärtige Halbraum des Heizers ist gewöhnlich durch einen Strahlungsreflektor abgeschlossen.

Es zeigt sich, daß u.U. ein Substrat nach der thermischen Behandlung Inhomogenitäten physikalischer Eigenschaften aufweist, die ein Flächenmuster entsprechend der Flächenstrukturierung des Heizers zeigen.

Aufgabe der vorliegenden Erfindung ist es, die Entstehung derartiger Inhomogenitäten zu verhindern.

Die Erfindung ist im Patentanspruch 1 beschrieben. Die Unteransprüche enthalten vorteilhafte Ausgestaltungen und Weiterbildungen der Erfindung.

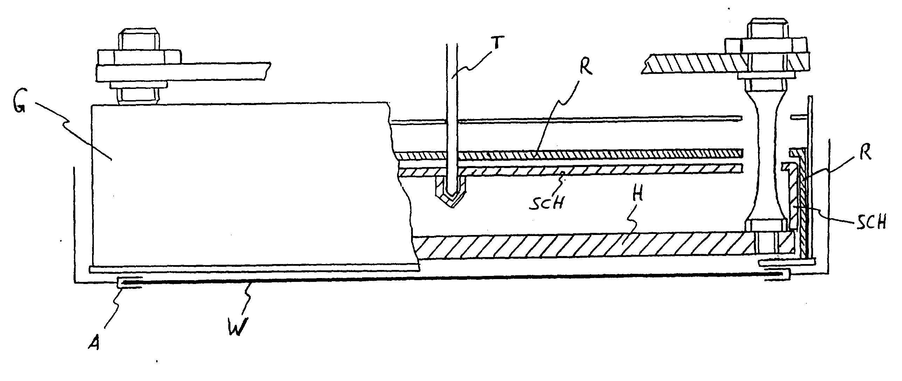

Die Erfindung ist nachfolgend unter Bezugnahme auf die Abbildung noch veranschaulicht.

Eine Heizvorrichtung enthält eine Aufnahme A für eine ebene Halbleitersubstratscheibe (Wafer) W. In einem Gehäuse G ist ein flächiger Heizer H angeordnet, der parallel zur Waferebene in geringem Abstand von dieser liegt und ungefähr die Waferfläche abdeckt. Das Gehäuse G ist zum Wafer W hin offen. Im rückwärtigen, d.h. der Substratebene abgewandten Halbraum des Heizers H ist in dem Gehäuse ein Mehrfachreflektor R, z.B. aus Tantal angeordnet.

Der Heizer weist durch Durchbrüche eine Strukturierung in der Fläche auf, insbesondere in Form einer Mäanderstruktur. Durch den Mäander fließt im Betrieb ein Heizstrom, der den Heizer je nach Anwendung auf Temperaturen deutlich über 1000°C aufheizen kann. Die Breite der benachbarte Mäanderabschnitte trennenden Durchbrüche im Heizkörper ist i.a. klein gegen die Breite der Mäanderzüge.

Erfindungsgemäß ist auf der dem Substrat abgewandten Seite des Heizers eine Abschirmung SCH vorgesehen, welche im wesentlichen aus demselben Material wie der Heizer selbst aufgebaut ist.

Das Fehlen von evtl. in geringen Anteilen im Heizermaterial auftretenden zusätzlichen Bestandteilen im Material der Abschirmung ist im Regelfall unerheblich.

Die Abschirmung ist als Platte oder vorzugsweise in Form eines Topfes innerhalb des Reflektortopfes vorgesehen. Auf diese Weise wird auch in Blickrichtung durch die Durchbrüche im Heizerkörper ein einheitlicher Materialhintergrund vorgegeben.

In dem abgebildeten Beispiels ist ein Thermoelement T als Sensor im Raum zwischen dem Heizer und der Abschirmung vorgegeben. Vorzugsweise wird dieses Sensorelement in seinem zwischen Heizer und Abschirmung befindlichen Umfang teilweise oder vollständig in Abschirmungsmaterial eingekapselt.

Das Heizermaterial und damit auch das Abschirmungsmaterial ist vorteilhafterweise Elektrographit, wobei Heizer und Abschirmung einschließlich der Kapselung des Sensorelements vorzugsweise mit pyrolithischem Elektrographit beschichtet sind.

Die Heizvorrichtung mit dem Wafer befindet sich zum Betrieb in einer Ultrahochvakuumkammer. Die in der Abbildung eingezeichneten mechanischen Befestigungselemente sind an sich bekannt und im einzelnen für die Erfindung ohne Bedeutung und daher nicht näher erläutert.

## Patentansprüche

1. Anordnung zur thermischen Behandlung von Halbleitersubstratscheiben mit einem flächigen Heizer aus elektrisch leitfähigem Widerstandsmaterial, wobei der Heizer parallel zur Substratebene und von dieser beabstandet angeordnet und in der Fläche eine Struktur in Form von Durchbrüchen aufweist, wobei auf der der Substratebene abgewandten Seite des Heizers eine flächige Abschirmung vorhanden ist, die im wesentlichen dieselbe Materialzusammensetzung wie der Heizer aufweist.

2. Anordnung nach Anspruch 1, dadurch gekennzeichnet, daß die Abschirmung durch Seitenwandungen einen die substratabgewandte Seite des Heizers abschließendes Topfelement bildet.

3. Anordnung nach Anspruch 1 oder 2, dadurch gekennzeichnet, daß sich mindestens ein Sensorelement zwischen Heizer und Abschirmung befindet und daß dieses Sensorelement durch Material von im wesentlichen derselben Zusammensetzung wie das Material des Heizers eingekapselt ist.

4. Anordnung nach einem der Ansprüche 1 bis 3, dadurch gekennzeichnet, daß der Heizer aus Elektrographit besteht.

5. Anordnung nach Anspruch 4, dadurch gekennzeichnet, daß der Heizer pyrolithisch beschichtet ist.

## Claims

1. Arrangement for thermal treatment of semiconductor substrate slices with an areal heater of electrically conductive resistance material, wherein the heater is arranged parallel to the substrate plane and spaced therefrom and has in the surface a structure in the form of interruptions, wherein an areal shielding, which has substantially the same material composition as the heater, is present on the side of the heater remote from the substrate plane.

2. Arrangement according to claim 1, characterised thereby that the shielding is formed by side walls and a pot element closing the side, which is remote from the substrate, of the heater.

3. Arrangement according to claim 1 or 2, characterised thereby that at least one sensor element is disposed between heater and shielding and that this sensor element is encapsulated by material of substantially the same composition as the material of the heater.

4. Arrangement according to one of claims 1 to 3, characterised thereby that the heater consists of electrographite.

5. Arrangement according to claim 4, characterised thereby that the heater is pyrolytically coated.

## Revendications

1. Dispositif de traitement thermique de disques de substrat semiconducteur équipé d'un organe de chauffage plan en matériau résistance électriquement conducteur, l'organe de chauffage étant disposé parallèlement au plan du substrat et écarté de celui-ci et présentant superficiellement une structure sous forme de découpures, sur le côté éloigné du plan du substrat de l'organe de chauffage étant prévu un écran plan, qui présente sensiblement la même composition matérielle que l'organe de chauffage.

2. Dispositif selon la revendication 1, caractérisé en ce que l'écran forme, à travers des parois latérales, en élément en pot obturant le côté éloigné du substrat de l'organe de chauffage.

3. Dispositif selon la revendication 1 ou 2, caractérisé en ce qu'au moins un capteur se trouve entre l'organe de chauffage et l'écran et en ce que ce capteur est encapsulé par un matériau sensiblement de même composition que le matériau de l'organe de chauffage.

4. Dispositif selon l'une quelconque des revendications 1 à 3, caractérisé en ce que l'organe de chauffage est en électrographite.

5. Dispositif selon la revendication 4, caractérisé en ce que l'organe de chauffage est revêtu de façon pyrolytique.
